# EUROPEAN PATENT APPLICATION

(11) **EP 0 764 980 A1**
(43) Date of publication of application: **26.03.1997**
(21) Application number: 96306831.7
(22) Date of filing: 19.09.1996
(51) Int. Cl.: H01L 21/762, H01L 21/32, H01L 21/316

(54) **Improved local oxidation of silicon**

(30) Priority: 20.09.1995 US 531883
(71) Applicant: Lucent Technologies Inc., Murray Hill, New Jersey 07974-0636 (US)
(72) Inventor: Gross, Michael Douglas, Allentown, Pennsylvania 18103 (US); Pearce, Charles Walter, Emmaus, Pennsylvania 18049 (US)
(74) Representative: Watts, Christopher Malcolm Kelway, Dr.

(57) **Abstract**

Twin tub formation and LOCOS processes are improved by forming an oxide layer from a chemical precursor upon a silicon substrate (11). The oxide (13) is covered with nitride (15) and both layers are patterned. Exposed portions of the subtrate (11) are oxidized and then the patterned layers are removed. The improved process reduces wafer scrap.

## Description

### Technical Field

This invention relates to methods of semiconductor integrated circuit fabrication.

### Background of the Invention

Many modern integrated CMOS circuits are formed by a twin tub process. In general, the twin tub process involves the formation of a blanket thermal oxide layer upon a silicon substrate. The blanket oxide is illustratively formed by exposing the silicon surface to an oxygen or steam ambient at an elevated temperature for a period of several hours. Next the blanket oxide layer is covered by a silicon nitride layer. Then both the silicon nitride and oxide layers are patterned. An ion implantation is performed to define one tub. Then the exposed portions of the silicon surface are thermally oxidized to create a thick oxide. Next, the patterned nitride/oxide layers are removed and a second ion implantation of an opposite conductivity type is performed. The second ion implantation step creates the second tub while the thick oxide protects the first-formed tub. Subsequently, the thick oxide is removed, thereby leaving a bare silicon surface with twin tubs of opposite conductivity type defined within the silicon body.

In addition, many modern integrated circuit manufacturing processes form thick oxide regions between individual transistors. These thick oxide regions are often termed "field oxides." Field oxides are often produced by a process termed the "LOCOS" process ("Local Oxidation Of Silicon"). In the LOCOS process, the surface of a silicon wafer is thermally oxidized to form a thin silicon dioxide layer. The thin silicon dioxide layer is covered by a silicon nitride layer. Then the silicon nitride and silicon dioxide layers are patterned together. Next, the wafer is exposed to a thermal oxidizing ambient. Exposed portions of the silicon wafer are oxidized in the ambient, thereby forming field oxides. Those portions of the wafer which are covered by the patterned silicon nitride/silicon dioxide layer are not oxidized.

In some variations of the process, a layer of polysilicon is formed between the silicon dioxide and the silicon nitride layer. In other variations, the field oxide may be formed in a trench which is first etched in the exposed silicon substrate.

Those concerned with the development of integrated circuits have consistently sought faster and more efficient methods of field oxide and twin tub formation.

### Summary of the Invention

The present invention addresses these concerns and illustratively includes:
forming a blanket layer of silicon dioxide from a chemical precursor upon the surface of a substrate;
forming a material layer on top of the silicon dioxide layer;
patterning the layer of silicon dioxide and the material layer to expose the surface of the substrate;
thermally oxidizing the surface of the substrate; and
removing at least the material layer.

### Brief Description of the Drawing

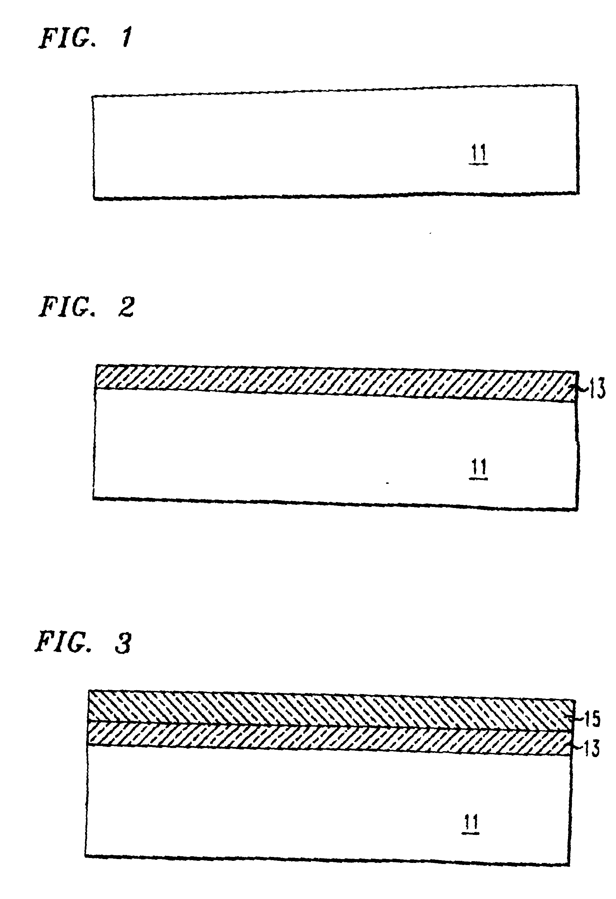

Figs. 1-6 are cross sectional views of a partially fabricated integrated circuit useful in understanding an embodiments of the present invention.

### Detailed Description

In Fig. 1, reference numeral 11 denotes a substrate which may be silicon, epitaxial silicon, or doped silicon. In general, the term substrate refers to a material upon which other material layers may be formed.

Reference numeral 13 denotes a layer of silicon dioxide, typically having a thickness of 100-500Å. Layer 13 is formed by a plasma enhanced chemical vapor deposition process (PECVD), utilizing a chemical precursor such as silane or TEOS. Other chemical precursors, known in the art, such as DADBS diacetoxyditertiarybutoxysilane or TMOS (tetramethoxysilane) or TOMCATS a trademark of Air Products and Chemicals, Inc. (tetramethylcyclotetrasiloxane) may also be utilized. Illustratively, layer 13 is formed in a single wafer reactor, such as the Applied Materials Precision 5000 Reactor manufactured by Applied Materials, Santa Clara, California. Appropriate values of temperature, gas flow, and pressure can be determine by those with skill in the art. Illustratively, the following parameters shown in Table 1 have produced desirable results:

**Table I**

| Oxide Formation Applied Materials 5000 Reactor | |
|---|---|
| Power (Watts) | 125 ±5% |
| Pressure (Torr) | 2.5 ±5% |
| Electrode Spacing (mils) | 350 ±5% |
| Temperature (°C) | 400±5°C |
| Silane Flow (sccm) | 25±5% |
| Nitrous Oxide Flow (sccm) | 600±5% |

In applicant's inventive process, layer 13 is formed individually upon each wafer, utilizing the aforementioned wafer apparatus. (Equipment manufactured by Novellus Inc. may also be utilized.) By contrast, previous practices utilized in formation of layer 13 involved thermal oxidation. In the thermal oxidation process, a group of approximately 100 wafers were loaded into a "boat" and subjected to an oxidizing ambient. This process produced 1-2% scrap, required a substantial investment in quartzware boats and placed an entire boatload - often 100 wafers - at risk every time a thermal oxidation process was performed. (Should the thermal oxidation process be defective, perhaps due to furnace or gas delivery malfunction, the entire boatload would be scrapped.) Applicant's process involves reduced investment in quartzware boats, produces ¼% scrap (in experiments conducted thus far), and places only 1 wafer at a time at risk in the single wafer oxidation apparatus. Furthermore, applicant's investigation shown that formation of undesirable particles upon a wafer is reduced by applicant's inventive process.

Turning to Fig. 3, layer 15 of silicon nitride, having a thickness between 1000 - 2000Å is formed on top of layer 13. Layer 15 is also formed by plasma enhanced chemical vapor deposition processes utilizing NH₃ and silane. Typical deposition parameters for temperature, gas flow and pressure are given in Table 2.

**Table 2**

| Silicon Nitride Formation Applied Materials 5000 Reactor | |
|---|---|
| Power (Watts) | 240 ± 5% |
| Pressure (Torr) | 4.1 ± 5% |
| Electrode Spacing (mils) | 600 ±5% |
| Temperature (°C) | 450 ±5°C |
| Silane Flow (sccm) | 75 ± 5% |
| Ammonia Flow (sccm) | 20 ± 5% |
| Nitrogen Flow (sccm) | 1175 ± 5% |

In Fig. 4, layers 15 and 13 have been patterned, leaving layers 151 and 131. Portions 17 and 19 of the upper surface of substrate 11 are exposed by the patterning process.

In Fig. 5, substrate 11 has been exposed to a thermal oxidation process. Field oxides 21 and 23 are produced. Typically, the thermal oxidation process is performed by exposing the substrate to a steam ambient at a temperature between 900 and 1000°C.

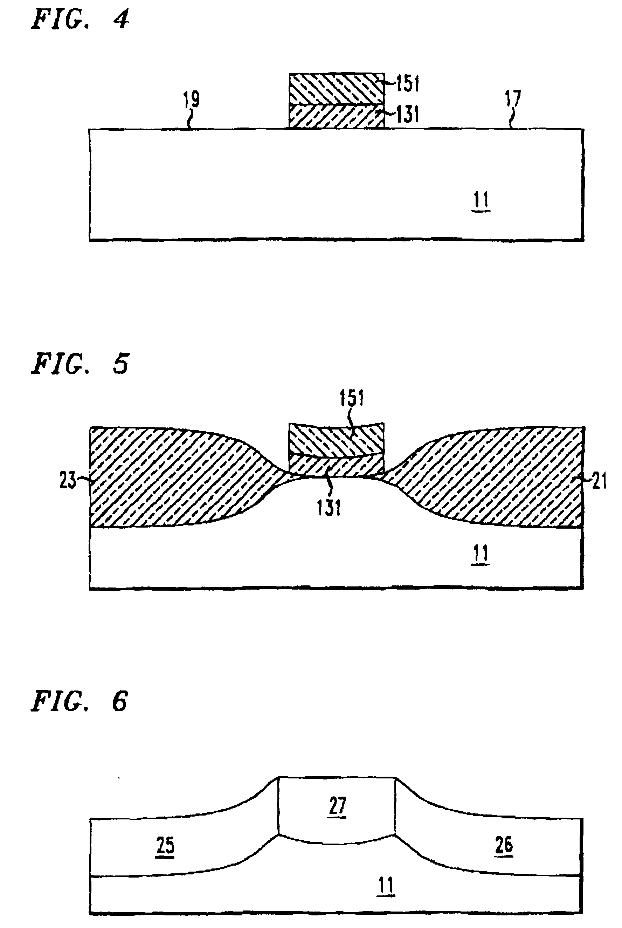

The present process may also be utilized to form masks suitable for twin tub formation. Figs. 1-5 may be reinterpreted to assist in understanding how a CMOS twin tub substrate may be formed. In Fig. 1, reference numeral 11 denotes a silicon substrate, as indicated before. In Fig. 2, blanket oxide layer 13 is formed From either silane or one of the other already-mentioned chemical precursors. In Fig. 3, blanket silicon nitride layer is formed on top of silicon dioxide layer 13. In Fig. 4, layers 15 and 13 are patterned, thereby creating mask layers 151 and 131. Next, an ion implantation step is performed, thereby creating a tub of first conductivity type in those portions of substrate 11 which are not masked by pattern layers 151 and 131. Next, turning to Fig. 5, exposed portions of substrate 11 are thermally oxidized, creating oxides 21 and 23. Patterned layers 151 and 131 are removed and a second ion implantation of a second conductivity type is performed, thereby create a second tub of opposite conductivity type from the first-formed tub. Fig. 6 illustrates substrate 11 with tubs 25 and 26 of same conductivity type and tub 27 of opposite conductivity type. (Oxides 21 and 23 have been removed).

Cycle time reduction due to incorporating applicant's inventive process at tub and field oxide levels is 14 hours.

## Claims

1. A method of forming an integrated circuit comprising:
forming a blanket layer of silicon dioxide (13) from a chemical precursor upon the surface of a substrate (11);
forming a material layer (15) on top of said silicon dioxide layer (13);
patterning said layer of silicon dioxide (13) and said material layer (15) to expose said surface (17,19) of said substrate (11);
thermally oxidizing said surface of said substrate: and
removing at least said material layer (151).

2. The method of claim 1 in which said material layer (15) is silicon nitride.

3. The method of claim 1 or claim 2 in which said chemical precursor is chosen from the group consisting of:
silane, diacetoxyditertiarybutoxysilane (DADBS), tetramethoxysilane, tetramethylcyclotetrasiloxane and TEOS.

4. The method of any of the preceding claims in which said thermal oxidation step produces a field oxide (23,21) and said removing step exposes a portion of the said surface of said substrate and further including the step of forming a gate upon said surface of said substrate.

5. The method of any of the preceding claims in which said blanket layer of silicon dioxide (13) is formed by PECVD.

6. The method of any of the preceding claims in which said blanket layer of silicon dioxide is formed in an Applied Materials 5000 reactor utilizing the following parameters:
| Applied Materials 5000 Reactor | |
|---|---|
| Power (Watts) | 125 ±5% |
| Pressure (Torr) | 2.5 ±5% |
| Electrode Spacing (mils) | 350 ±5% |
| Temperature (°C) | 400 ±5°C |
| Silane Flow (sccm) | 25 ±5% |
| Nitrous Oxide Flow (sccm) | 600 ±5% |

7. The method of any of the preceding claims further including performing a first ion implantation step before said thermal oxidation step.

8. The method of claim 7 further including performing a second ion implantation step after said removal step.
